# EUROPEAN PATENT SPECIFICATION

(11) **EP 1 177 870 B1**
(45) Date of publication and mention of the grant of the patent: **16.05.2007**
(21) Application number: 01118604.6
(22) Date of filing: 02.08.2001
(51) Int. Cl.: B28D 1/24, B28D 1/22, C03B 33/10

(54) **A cutter wheel for forming scribe lines on brittle materials**
Schneidrad zum Einkerben von spröden Materialien
Molette pour entailler des matériaux cassants

(30) Priority: 04.08.2000 JP 2000237241
(43) Date of publication of application: 06.02.2002
(73) Proprietor: Mitsuboshi Diamond Industrial Co., Ltd., Suita-city, Osaka Pref. 564-0044 (JP)
(72) Inventor: Soyama, Hiroshi, Mitsuboshi Diamond Industrial Co., Suita-city, Osaka Pref. 564-0044 (JP); Maekawa, Kazuya, Mitsuboshi Diamond Industrial Co., Suita-city, Osaka Pref. 564-0044 (JP)
(74) Representative: TBK-Patent

(56) References cited:
- EP-A- 0 978 490
- US-A- 1 962 238

## Description

### FIELD OF THE INVENTION

The present invention relates to a cutter wheel for forming scribe lines on a brittle material according to the preamble of claim 1.

### DESCRIPTION OF PRIOR ART

A prior art cutter wheel of this type is produced in a following manner. A disk wheel is first fabricated by grinding the circumference of a disk-like material made of a cemented carbide alloy, sintered diamond or the like so as to form a V-shaped edge. The disk wheel is further ground around the center thereof to form a through-hole, to which a rotation shaft is fitted. The disk wheel fabricated as mentioned is supported in a recess of a chip holder by mounting the rotation shaft in a rotatable manner. The rotation shaft is made of iron, a cemented carbide alloy, sintered diamond or the like.

In case that a cutter provided with a cutter wheel and a rotation shaft made of materials different from each other is used, for example, if the wheel is made of a cemented carbide alloy and the shaft is made of iron, then the shaft is abraded remarkably, so that the cutter wheel becomes not to be rotated smoothly. Accordingly, the quality of a scribing line becomes worse in a short time. On the other hand, if the wheel is made of a cemented carbide alloy and the shaft is made of sintered diamond, the inner diameter of the through-hole for fitting the shaft becomes larger due to abrasion between the wheel and the shaft. Accordingly, the cutter wheel becomes not to be rotated smoothly, though it takes a longer time than the previous case. Further, such a combination of different materials makes a product expensive.

Therefore, it is conventional to make the cutter wheel and the rotation shaft by making use of a same material. However, if the same material is used, heat is generated due to abrasion between them, and seizure between them happens. Resultantly, the rotation of the cutter wheel becomes not smooth. If a cutting object is a glass sheet, glass fibers are generated thereby resulting in problems of scribe quality in a short time while scribing is made.

EP-A-0 978 490 discloses a generic cutter wheel for forming scribe lines on a brittle material. The cutter wheel comprises a disk with two side planes, with a V-shaped edge formed at the outer periphery thereof, and a shaft hole formed at the center thereof for inserting a rotational shaft, wherein at least one groove extends from a first surface of said side planes along said shaft hole.

### SUMMARY OF THE INVENTION

It is an object of the present invention to further develop a cutter wheel for forming scribe lines on a brittle material according to the preamble of claim 1 such that the heat generated due to abrasion between the wheel and a shaft is decreased largely.

This object is achieved by a cutter wheel having the features of claim 1.

Advantageous further developments are defined in the dependent claims.

An advantage of the present invention is that the cutter wheel is capable of forming scribe lines of a high quality at a higher scribing speed in a longer length of scribe lines compared with a prior art one.

The groove in the cutter wheel according to the invention may be provided in various ways. Their number, size and locations are varied in the following manner. For example, the groove may extend in an axial direction. The groove may have a length in the axial direction of one to three quarters of the thickness of the cutter wheel. The groove may extend obliquely or spirally to the axial direction. The depth of recesses formed in the side planes other than the groove, may be set to about one to three quarters of the thickness of the cutter wheel. It is effective that the cutter wheel and the rotation shaft is made of a same material.

It is another advantage of the present invention that the cutter wheel can be rotated smoothly so that the scribing is performed smoothly.

### BRIEF DESCRIPTION OF THE DRAWINGS

These and other advantages and features of the present invention will become clear from the following description taken in conjunction with the preferred embodiments thereof with reference to the accompanying drawings, and in which:
Figs. 1A and 1B are a side view and a sectional view of a cutter wheel of an embodiment;
Figs. 2A, 2B and 2C are sectional views of grooves of cutter wheels;
Figs. 3A and 3B are diagrams for illustrating a prior art cutting wheel and a cutting wheel of the present invention fitted to a holder;
Figs. 4A and 4 B are a side view and a sectional view of a cutter wheel of another embodiment;
Figs. 5A and 5B are a side view and a sectional view of a cutter wheel of a still another embodiment;
Figs. 6A and 6B are a side view and a sectional view of a cutter wheel of a still another embodiment;
Figs. 7A and 7B are a side view and a sectional view of a cutter wheel of a still another embodiment;
Figs. 8A and 8B are a side view and a sectional view of a cutter wheel of a still another embodiment;
Figs. 9A and 9B are a side view and a sectional view of a cutter wheel of a still another embodiment;
Figs. 10A and 10B are a side view and a sectional view of a cutter wheel of a still another embodiment;
Figs. 11A and 11B are a side view and a sectional view of a cutter wheel of a still another embodiment;
Figs. 12A and 12B are a side view and a sectional view of a cutter wheel of a still another embodiment;
Figs. 13A and 13B are a side view and a sectional view of a cutter wheel of a still another embodiment;
Figs. 14A and 14B are a side view and a sectional view of a cutter wheel of a still another embodiment;
Figs. 15A and 15B are a side view and a sectional view of a cutter wheel of a still another embodiment;
Fig. 16 is a diagram for illustrating a situation for fitting a bush to a cutter wheel material;
Fig. 17 is another diagram for illustrating a situation for fitting a bush to a cutter wheel material; and
Fig. 18 is a still another diagram for illustrating a situation for fitting a bush to a cutter wheel material.

### DETAILED DESCRIPTION OF THE PREFERRED EMBODIMENTS

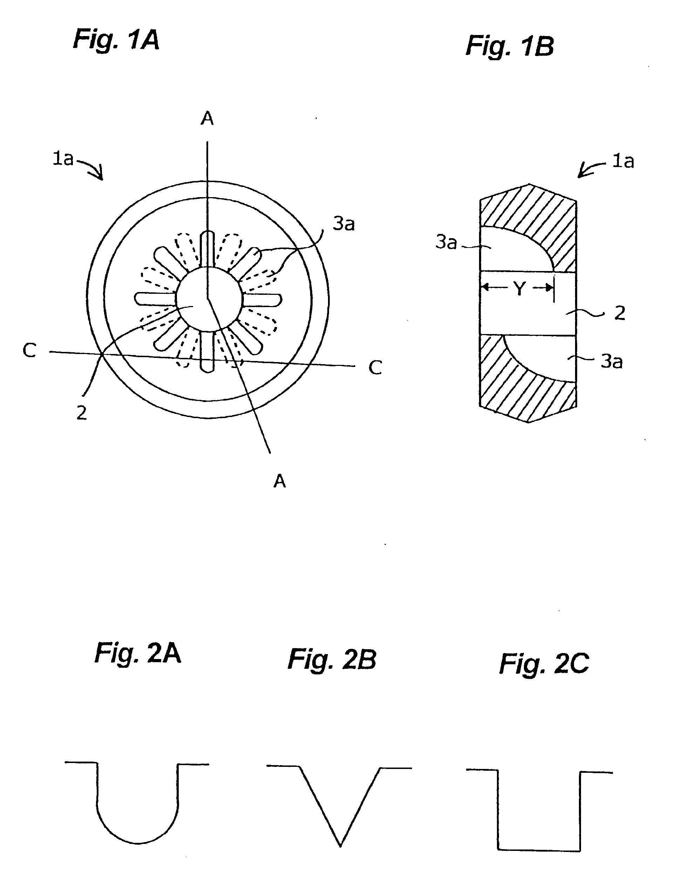

Referring now to the drawings, wherein like reference characters designate similar or corresponding parts throughout the several views, Figs. 1A is a side view of a cutter wheel 1a according to an embodiment of the present invention, and Fig. 1B is a sectional view along line A-A in Fig. 1A. The cutter wheel 1a has a circumference with a V-shaped edge and a shaft hole 2 around the center thereof, to which a rotation shaft for the cutter wheel 1a is inserted. Thus, the wheel 1a has an outer diameter and an inner diameter. Further, at the inner peripheral plane of the shaft hole 2, eight grooves 3a ( represented by solid lines ) of a predetermined length are formed at an equal distance between them along the axial direction (or a direction of the thickness of the wheel ) extending from a first side plane to a second one.

On the other hand, additional eight grooves 3a ( represented by broken lines ) of the predetermined length are similarly formed at the equal distance between them extending in the axial direction and in the opposite direction from the second side plane to the first one. In Fig. 1A, the first grooves 3a represented by solid lines and the second ones 3a represented by broken lines observed from the first side plane of the wheel are located in a state having inverted phases between them. That is, a first groove 3a is lacated at the center between two second grooves, or vice versa, when observed from a side plane of the wheel. The depth of the grooves 3a in the radial direction decreases from the surface of the side plane to the inside thereof.

The grooves 3a observed in section C-C in Figs. 1A and 1B has a U-shaped form shown in Fig. 2A. However, it may have a V-shaped form as shown in Fig. 2B or a rectangular shape as shown in Fig. 2C. The grooves of different shapes have similar functions and advantages.

The width of the groove 3a is, for example, 1/48 to 1/2 of the circumference length of the shaft hole 2, depending on the outer diameter of the cutter wheel 1a. The depth (T) of the groove 3a in the radial direction from the axial center of the cutter wheel is selected so that 1/20 < T/S < 1 wherein S denotes a difference between the outer radius and the inner radius of the cutter wheel.

In an example of this embodiment, the inner diameter of the cutter wheel 1a is 0.8 mm, the width of the groove 3a is about 0.15 mm, and the depth thereof is about 0.4 mm.

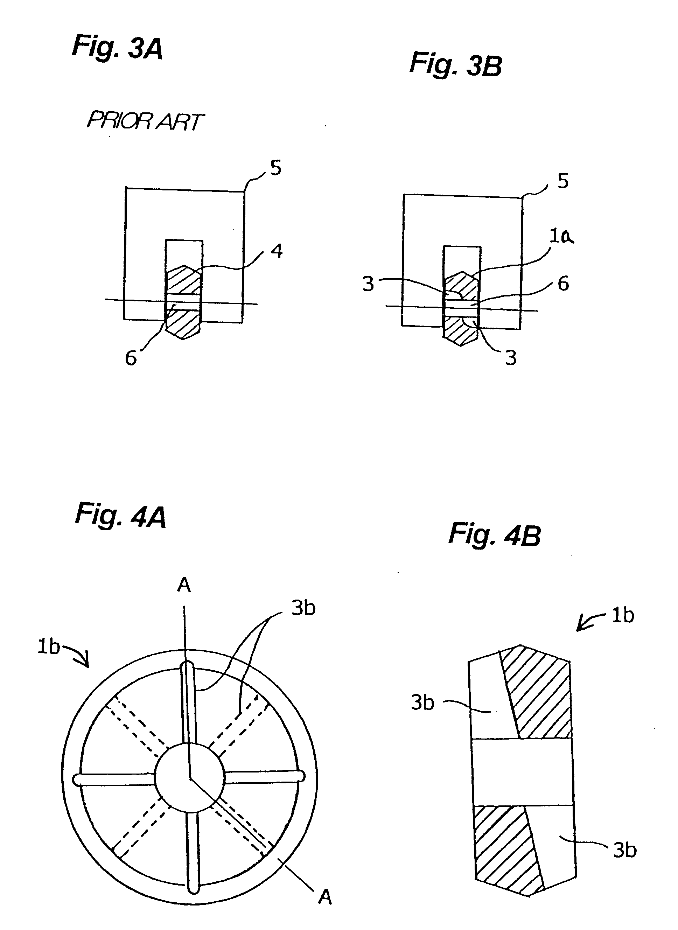

Figs. 3A and 3B illustrate a prior art cutting wheel 4 and a cutting wheel 1a of the present invention fitted to shafts 6. The shafts 6 are further mounted to chip holders 5 in a rotatable manner. As will be understood by comparing Figs. 3A and 3B, in the case of the cutter wheel 1a of this embodiment shown in Fig. 3B (and of the other embodiments to be explained below ), the contact area of the inner peripheral plane of the wheel 1a with the shaft 6 is decreased largely than the counterpart of a combination of the prior art cutter wheel 4 with the shaft 6 shown in Fig. 3A. The contact area of the two side planes of the wheel 1a with an inner wall of the chip holder 5 is also decreased. Accordingly, the abrasion resistance can be decreased while the cutter wheel is rotated.

Further, there is a clearance between the inner wall of the chip holder 5 and the side planes of the cutter wheel 1a, though very small. The grooves 3a take ambient air at the two side planes of the wheel 1a and remove dusts generated due to the abrasion between the inner peripheral plane of the shaft hole 2 and the shaft 6, and between the inner wall of the chip holder 5 and the side planes of the wheel 1a, while suppressing heat generation by the abrasion.

The length Y in the axial direction of the groove 3a, shown in Fig. 1B, is the most advantageous for the decrease on abrasion when it is about 3/4 of the thickness of the cutter wheel 1a.

When a shaft 6 made of a cemented carbide alloy is combined with a cutter wheel 1a made of the same material, a test is performed on the cutter wheel of the present invention and on the prior art cutter wheel to examine how long scribing is possible until a defective is observed. Table 1 shows the result of the measured distance.

**TABLE 1 Test result**

| | |
|---|---|
| Cutter wheel of the invention : | 1,000 - 2,000 m |
| Cutter wheel of a prior art : | 10-20m |

The scribing conditions for the test is as follows. The object subjected for scribing is a soda glass sheet. The scribing speed is 300 mm/s. The weight at the edge of the cutter wheel is 1.1 kg. The outer diameter of the cutter wheel is 2.5 mm, the thickness thereof is 0.65 mm, the inner diameter thereof is 0.8 mm, the edge angle at the edge is 120 degree, and the outer diameter of the shaft 6 is 0.8 mm. The shaft 6 is fixed completely, or only the cutter wheel 1a is rotated while scribing. Further, scribing lines are formed on the glass sheet in parallel with a distance of 0.5 mm between them.

As will be understood from the result shown in Table 1, the scribing performance of the cutter wheel 1a of the present invention is improved by 100 to 200 times if compared with the prior art cutter wheel 4.

A various types of cutter wheels are possible, and some of them are further explained below.

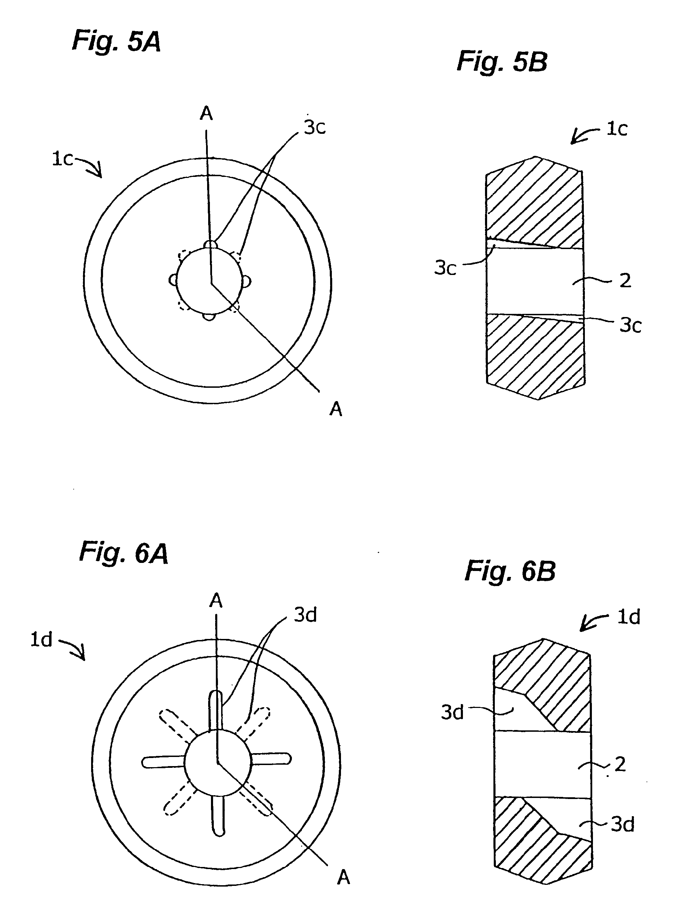

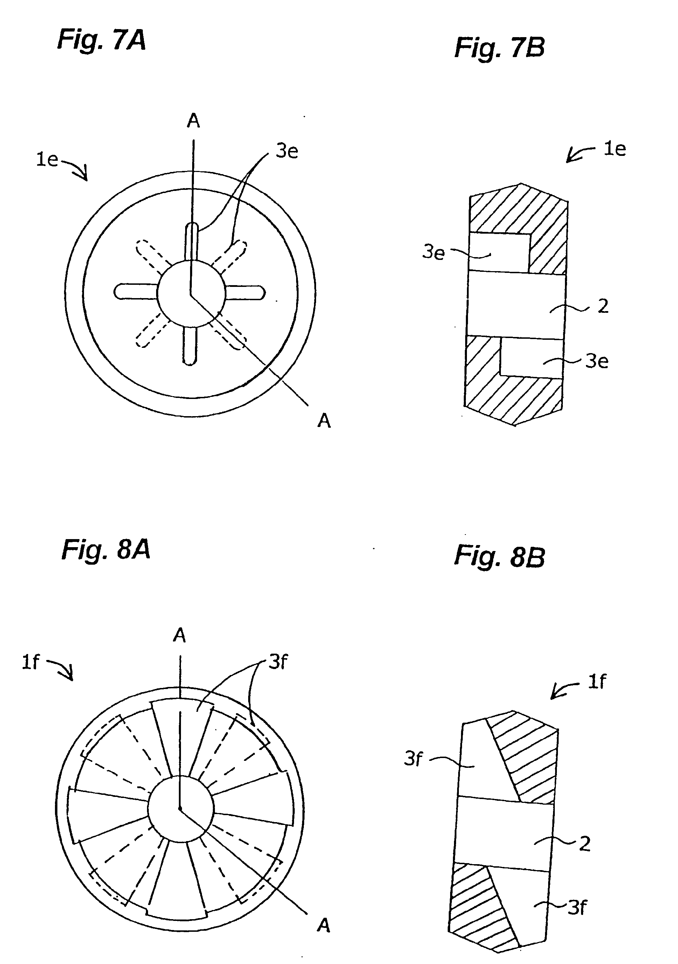

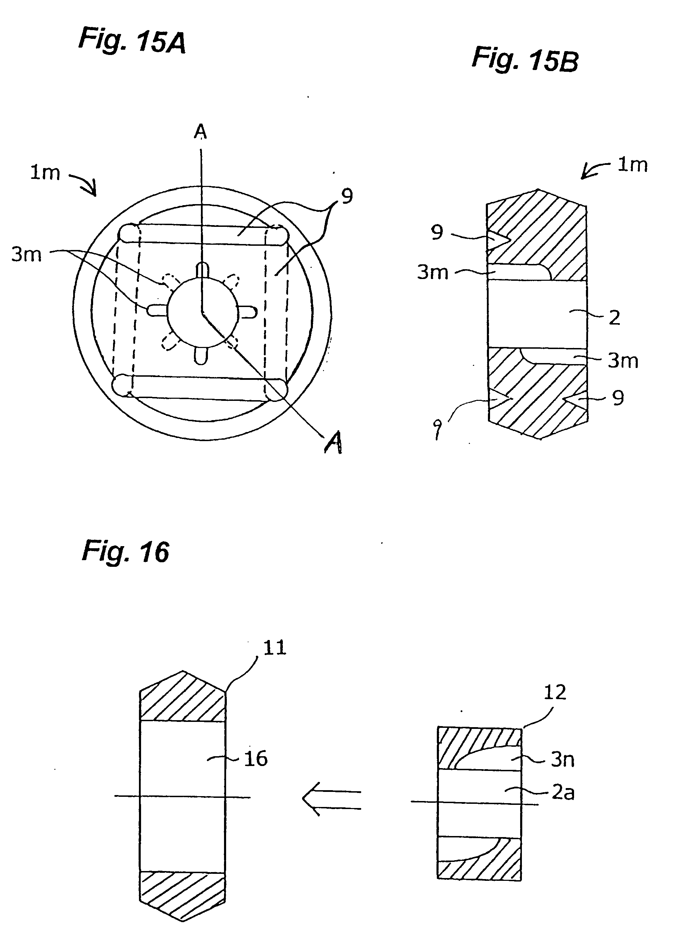

Figs. 4A and 4 B to 15A and 15B show different examples of the grooves. In cutter wheels 1b and 1c shown in Figs. 4A and 4B, and Figs. 5A and 5B, the depth of the grooves 3b and 3c is varied linearly along the axial direction (or thickness direction of the cutter wheel ). The grooves 3c shown in Figs. 5A and 5B have a gentler slope than the counterparts 3b shown in Figs. 4A and 4B. In a cutter wheel 1d shown in Figs. 6A and 6B, the depth of grooves 3d is varied at two stages in the axial direction. In a cutter wheel 1e shown in Figs. 7A and 7B, the depth of grooves 3e is constant in the axial direction.

A cutter wheel If shown in Figs. 8A and 8B has eight grooves 3f having sections similar to the counterparts shown in Figs. 4A and 4B. However, the groove 3f has a width increasing with distance increase from the inner peripheral plane of the hole 2.

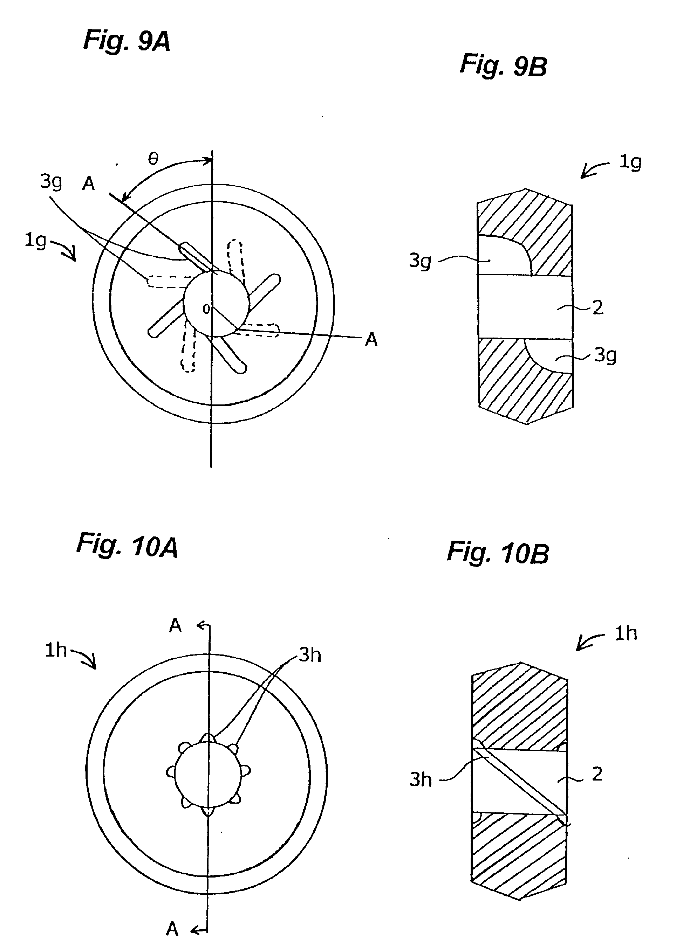

A cutter wheel 1g shown in Figs. 9A and 9B has eight grooves 3g having sections similar to the counterparts shown in Figs. 1A and 1B. The grooves 3g extend in the thicknss direction, as in the previous embodiments. However, the grooves 3g are inclined by an angle 'theta' relative to the radial direction whereas the counterparts 3a shown in Figs. 1A and 1B extend in the radial direction. By forming grooves 3g extending obliquely by a predetermined angle from the radial direction, as explained above, it becomes easier to take ambient air around the side planes of the rotating wheel 1g. This suppresses effectively the generation of heat due to the abrasion between the inner peripheral wall of the cutter wheel 1g and the shaft.

A cutter wheel 1h shown in Figs. 10A and 10B has four grooves 3h which extend along the inner peripheral wall of the hole 2 obliquely relative to the axal direction, to the other side plane to a point symmetrical to the center of the cutter wheel 1h. The sectional shape of the groove 3h may be V-shaped, trapezoidal, U-shaped, or the like forms.

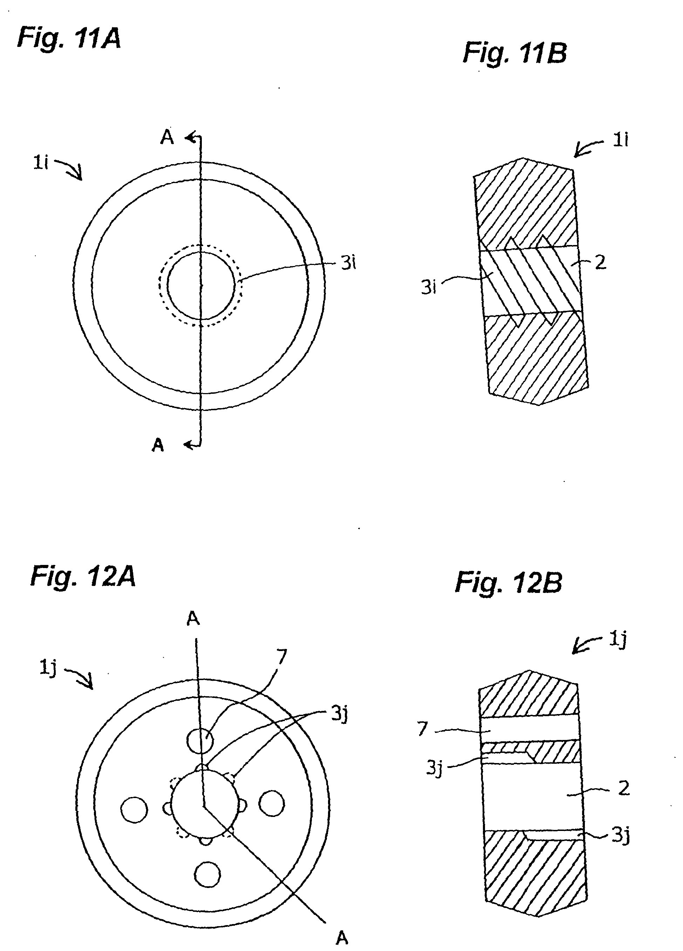

A cutter wheel 1i shown in Figs. 11A and 11B has a spiral groove 3i extending along the inner peripheral wall of the hole 2. The spiral pitch is set to be 0.1 to 1.5 mm. The sectional shape of the groove 3i may be V-shaped, trapezoidal, U-shaped, or the like forms. Though Figs. 11A and 11B show an example of the cutter wheel 1i having one spiral groove 3i, it is more preferable that it has a plurality of grooves 3i.

A cutter wheel 1j shown in Figs. 12A and 12B has eight grooves 3j formed along the shaft hole 2. Further, it has four through-holes 7 extending in the thickness direction of the wheel 1j. The four holes 7 are arranged between the outer periphery and the hole 2 at an equal distance between them, symmetrically relative to the center of the hole 2.

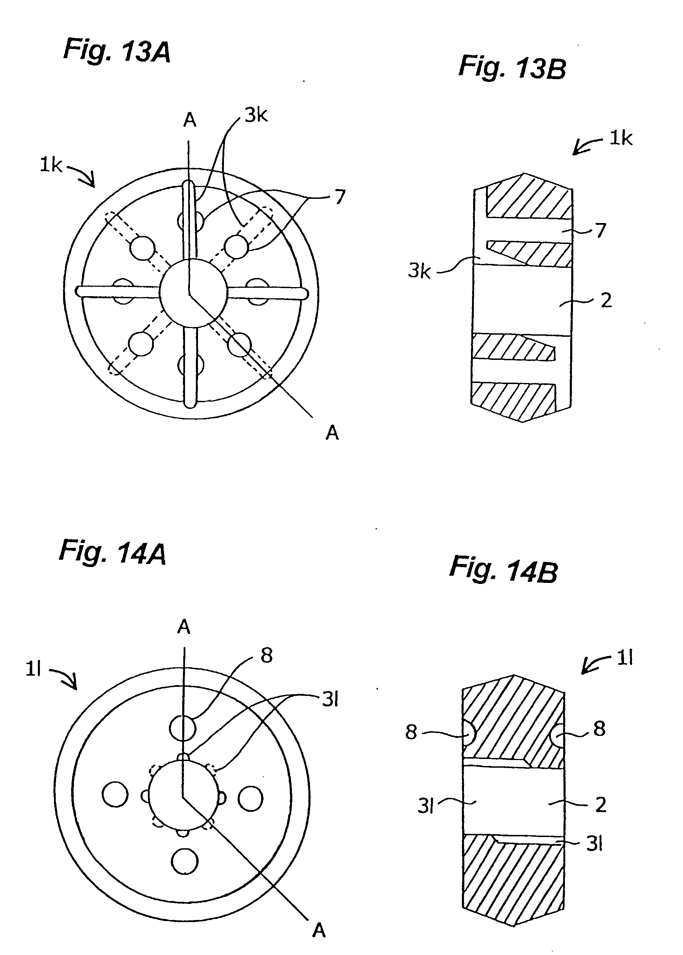

A cutter wheel 1k shown in Figs. 13A and 13B has eight through-holes 7 extending in the thickness direction thereof as well as eight grooves 3k formed along the shaft hole 2. Further, the groove 3k extends towards the outer periphery near the side plane, and it is connected to the hole 7.

A cutter wheel 1*I* shown in Figs. 14A and 14B has four recesses 8 of a predetermined depth in each side plane of the cutter wheel 1*I*, besides eight grooves 31 formed around the inner peripheral plane at the shaft hole 2. The recesses 8 have a semi-spherical shape.

A cutter wheel 1m shown in Figs. 15A and 15B has two recesses 9 of a predetermined depth in each side plane of the cutter wheel 1m, besides eight grooves 3m formed along the shaft hole 2. The recess 9 extends linearly and perpendicularly to the radial direction as shown in Fig. 15A.

A cutter wheel 1 can also be fabricated by combining a bush to a cutter wheel material, as explained below. By using such a cutter wheel 1 fabricated by fitting or inserting the bush to the cutter wheel material, similar advantage can be realized as the above-mentioned cutter wheels.

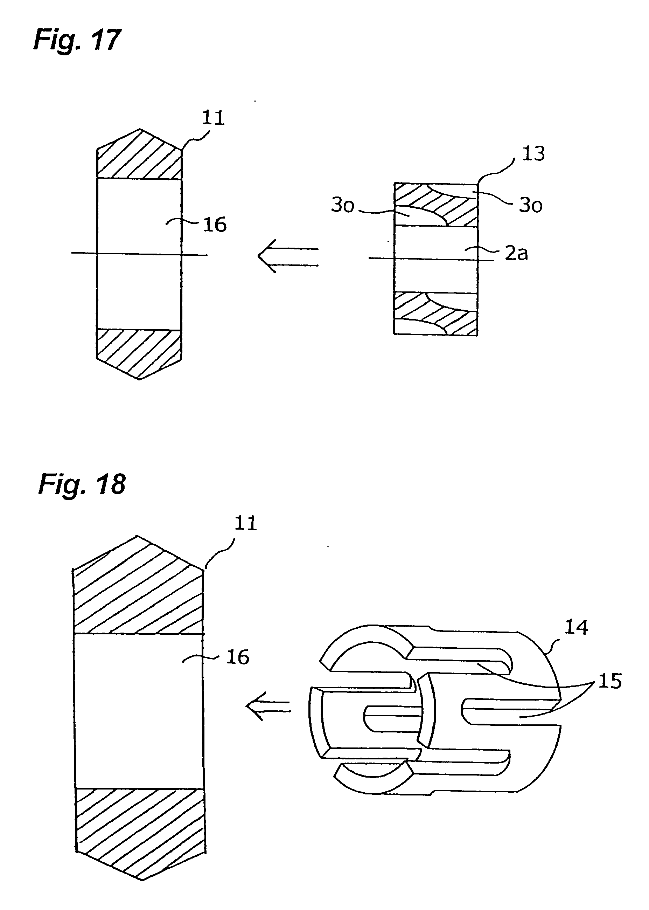

Fig. 16 illustrates a situation for fitting or inserting a disk-like bush 12 to a cutter wheel material 11 having a circular inner hole 16 for fabricating a cutter wheel. The bush 12 has a through-hole 2a and a plurality of grooves 3n, similarly to the various cuter wheels explained above, extending from one surface of the side planes along the inner peripheral plane of the hole 2a and in the radial direction. Fig. 17 illustrates another situation for fitting a bush 13 to a cutter wheel material 11. The bush 13 has grooves 3o along the inner peripheral plane of the hole 2a and along an outer peripheral plane. The grooves 3o extend from each one surface of side planes in the radial direction. The outer peripheral plane of the bushes 12 and 13 is fitted or inserted to a circular hole 16 of the cutter wheel material 11 to fabricate a cutter wheel.

The grooves 3n and 3o in the bushes 12 and 13 may have various forms as adopted in the above-mentioned cutter wheels. For example, the grooves 3n and 3o may be formed alternately at the two side planes of the bushes 12 and 13 as shown in Fig. 1. Further, the grooves 3n and 3o in the bushes 12 and 13 may be formed at equal intervals between them. Still further, the grooves 3n and 3o in the bushes 12 and 13 may be formed to have a predetermined angle relative to the radial direction at the two side planes of the bushes 12 and 13, as shown in Fig. 9. In another way, the bushes 12 and 13 may be formed to have recesses or through-holes, as shown in Figs. 12 to 15. Further, various features of the grooves, recesses and through-holes may also be combined.

Fig. 18 illustrates a still another situation for fitting a bush 14 to a cutter wheel material 11. The bush 14 has a cylindrical shape, and it has cut-away portions 15 extending from each one of the ends thereof in the axial direction. The outer peripheral plane of the bush 14 is fitted or inserted to an inner circular hole 16 of the cutter wheel material 11 to fabricate a cutter wheel.

The cut-away portions 15 in the bush 14 may also have various forms. The cut-away portions 15 in the bush 14 may be formed alternately as shown in Fig. 9 at the two side planes of the bush 14. Further, the cut-away portions 15 in the bush 14 may be formed at an equal interval between them. Still further, the cut-away portions 15 may be formed to have a predetermined angle relative to the radial direction at the two side planes of the bush 14. The cut-away portions 15 may have a length of one to three quarters of the length of the bush 14 in the radial direction.

The grooves as explained above may also be formed at the shaft hole of a different type of cutter wheels. That is, the grooves may be formed for a cutter wheel having an edge at the outer with a microscopic structure as described in the United States Patent No. 5,836,229 for Wakayama et al.

In the above-mentioned cutter wheels, grooves are provided along the axial direction, obliquely to the axial direction or spirally at the inner peripheral plane for inserting the rotation shaft. Therefore, abrasion resistance is decreased between the inner peripheral plane thereof and the rotation shaft and between the cutter wheel and the inner wall of the chip holder. Thus, the cutter wheel can be rotated smoothly, and defective scribing becomes harder to happen.

Further, by providing recesses or through-holes in a cutter wheel, dusts due to abrasion can be removed. Therefore, the performance of the cutter wheel is increased 100 to 200 times if it is evaluated on scribing length tests.

Although the present invention has been fully described in connection with the preferred embodiments thereof with reference to the accompanying drawings, it is to be noted that various variations and modifications are to be understood as included within the scope of the present invention as defined by the appended.

## Claims

1. A cutter wheel (1a; 1b; 1c; 1d; 1e; 1f; 1g; 1h; 1i; 1j; 1k; 11; 1m; 1l) for forming scribe lines on a brittle material, comprising:
a disk with two side planes, with a V-shaped edge formed at the outer periphery thereof,
and with a shaft hole (2) formed at the center thereof for inserting a rotational shaft (6),
wherein at least one groove (3a; 3b; 3c; 3d; 3e; 3f; 3g; 3h; 3i; 3j; 3k; 3l; 3m; 3n; 3o) extends from a first surface of said side planes along said shaft hole (2),
**characterized in that**
said at least one groove (3a; 3b; 3c; 3d; 3e; 3f; 3g; 3h; 3i; 3j; 3k; 3l; 3m; 3n; 3o) when viewed in the axial direction has a length which is smaller than the thickness of the cutter wheel (1a; 1b; 1c; 1d; 1e; 1f; 1g; 1h; 1i; 1j; 1k; 11; 1m; 1l).

2. A cutter wheel (1a; 1b; 1c; 1d; 1e; 1f; 1g; 1h; 1i; 1j; 1k; 1l; 1m; 11) according to claim 1, wherein said at least one groove (3a; 3b; 3c; 3d; 3e; 3f; 3g; 3h; 3i; 3j; 3k; 31; 3m; 3n; 3o) extends in the axial direction.

3. A cutter wheel (1a; 1b; 1c; 1d; 1e; 1f; 1g; 1h; 1i; 1j; 1k; 11; 1m; 1l) according to claim 2, wherein said at least one groove (3a; 3b; 3c; 3d; 3e; 3f; 3g; 3h; 3i; 3j; 3k; 3l; 3m; 3n; 3o) has a length in the axial direction of one to three quarters of the thickness of the cutter wheel (1a; 1b; 1c; 1d; 1e; 1f; 1g; 1h; 1i; 1j; 1k; 11; 1m; 1l).

4. A cutter (1a; 1b; 1c; 1d; 1e; 1f; 1g; 1h; 1i; 1j; 1k; 11; 1m; 1l) wheel according to claim 1, wherein said at least one groove (3a; 3b; 3c; 3d; 3e; 3f; 3g; 3h; 3i; 3j; 3k; 31; 3m; 3n; 3o) extends obliquely to the axial direction.

5. A cutter wheel (1a; 1b; 1c; 1d; 1e; 1f; 1g; 1h; 1i; 1j; 1k; 1l; 1m; 1l) according to claim 4, wherein said at least one groove (3a; 3b; 3c; 3d; 3e; 3f; 3g; 3h; 3i; 3j; 3k; 31; 3m; 3n; 3o) extends spirally along the shaft hole (2).

6. A cutter wheel (1a; 1b; 1c; 1d; 1e; 1f; 1g; 1h; 1i; 1j; 1k; 1l; 1m; 1l) according to claim 1, wherein said at least one groove (3a; 3b; 3c; 3d; 3e; 3f; 3g; 3h; 3i; 3j; 3k; 3l; 3m; 3n; 3o) has a rectangular shape with cross section of a form selected from U-shaped and V-shaped forms.

7. A cutter wheel (1a; 1b; 1c; 1d; 1e; 1f; 1g; 1h; 1i; 1j; 1k; 1l; 1m; 11) according to claim 1, wherein a depth of said at least one groove (3a; 3b; 3c; 3d; 3e; 3f; 3g; 3h; 3i; 3j; 3k; 3l; 3m; 3n; 3o) decreases from one surface of said side planes towards the inside thereof.

8. A cutter wheel (1a; 1b; 1c; 1d; 1e; 1f; 1g; 1h; 1i; 1j; 1k; 11; 1m; 1l) according to claim 1, wherein a depth of said at least one groove (3a; 3b; 3c; 3d; 3e; 3f; 3g; 3h; 3i; 3j; 3k; 3l; 3m; 3n; 3o) is constant along the axial direction.

9. A cutter wheel (1a; 1b; 1c; 1d; 1e; 1f; 1g; 1h; 1i; 1j; 1k; 1l; 1m; 11) according to claim 1, wherein said at least one groove (3a; 3b; 3c; 3d; 3e; 3f; 3g; 3h; 3i; 3j; 3k; 3l; 3m; 3n; 3o) is formed at an equal distance therebetween.

10. A cutter wheel (1a; 1b; 1c; 1d; 1e; 1f; 1g; 1h; 1i; 1j; 1k; 1l; 1m; 11) according to claim 1, wherein said at least one groove (3a; 3b; 3c; 3d; 3e; 3f; 3g; 3h; 3i; 3j; 3k; 31; 3m; 3n; 3o) comprises first grooves extending from one of said side planes and second grooves extending from the other of said side planes, and
said first and second grooves are located alternately in the circumference direction of said shaft hole (2).

11. A cutter wheel (1a; 1b; 1c; 1d; 1e; 1f; 1g; 1h; 1i; 1j ; 1k; 11; 1m; 1l) according to claim 1, wherein said at least one groove (3a; 3b; 3c; 3d; 3e; 3f; 3g; 3h; 3i; 3j; 3k; 31; 3m; 3n; 3o) has a width increasing with distance increase from said shaft hole (2).

12. A cutter wheel (1a; 1b; 1c; 1d; 1e; 1f; 1g; 1h; 1i; 1j; 1k; 11; 1m; 1l) according to claim 1, further comprising at least one through-hole (7) extending in the thickness direction of the cutter wheel (1a; 1b; 1c; 1d; 1e; 1f; 1g; 1h; 1i; 1j; 1k; 1l; 1m; 1l).

13. A cutter wheel (1a; 1b; 1c; 1d; 1e; 1f; 1g; 1h; 1i; 1j; 1k; 11; 1m; 1l) according to claim 12, wherein one of said at least one through-hole (7) is connected to one of said at least one groove (3a; 3b; 3c; 3d; 3e; 3f; 3g; 3h; 3i; 3j; 3k; 3l; 3m; 3n; 3o).

14. A cutter wheel (1a; 1b; 1c; 1d; 1e; 1f; 1g; 1h; 1i; 1j; 1k; 1l; 1m; 11) according to claim 1, further comprising at least one recess (8; 9) formed at at least one of said side planes thereof.

15. A cutter wheel (1a; 1b; 1c; 1d; 1e; 1f; 1g; 1h; 1i; 1j; 1k; 11; 1m; 1l) according to claim 14, wherein said at least one recess (8; 9) has a semi-spherical shape.

16. A cutter wheel (1a; 1b; 1c; 1d; 1e; 1f; 1g; 1h; 1i; 1j; 1k; 1l; 1m; 1l) according to claim 14, wherein said at least one recess (8; 9) extends perpendicularly to the radial direction of the cutter wheel (1a; 1b; 1c; 1d; 1e; 1f; 1g; 1h; 1i; 1j ; 1k; 1l; 1m; 11).

17. A cutter comprising:
a cutter wheel (1a; 1b; 1c; 1d; 1e; 1f; 1g; 1h; 1i; 1j; 1k; 1l; 1m; 11) according to one of claims 1 to 16;
a rotation shaft (6) fitted to the shaft hole (2) of said cutter wheel (1a; 1b; 1c; 1d; 1e; 1f; 1g; 1h; 1i; 1j; 1k; 1l; 1m; 11); and
a holder (5) supporting said rotation shaft (2).

## Patentansprüche

1. Schneidrad (1a; 1b; 1c; 1d; 1e; 1f; 1g; 1h; 1i; 1j; 1k; 1l; 1m; 11) zum Ausbilden von Kerblinien auf einem spröden Material mit:
einer Scheibe mit zwei Seitenebenen, mit einer V-förmigen Kante, welche an ihrem Außenumfang ausgebildet ist,
und mit einem Wellenloch (2), welches in ihrer Mitte ausgebildet ist, zum Einführen einer Drehwelle (6), wobei sich mindestens eine Nut (3a; 3b; 3c; 3d; 3e; 3f; 3g; 3h; 3i; 3j; 3k; 3l; 3m; 3n; 3o) von einer ersten Fläche der Seitenebenen entlang des Wellenlochs (2) erstreckt,
**dadurch gekennzeichnet, dass**
die mindestens eine Nut (3a; 3b; 3c; 3d; 3e; 3f; 3g; 3h; 3i; 3j; 3k; 3l; 3m; 3n; 3o), wenn in der axialen Richtung betrachtet, eine Länge hat, welche kleiner ist als die Dicke des Schneidrads (1a; 1b; 1c; 1d; 1e; 1f; 1g; 1h; 1i; 1j; 1k; 1l; 1m; 11).

2. Schneidrad (1a; 1b; 1c; 1d; 1e; 1f; 1g; 1h; 1i; 1j; 1k; 11; 1m; 1l) nach Anspruch 1, wobei sich die mindestens eine Nut (3a; 3b; 3c; 3d; 3e; 3f; 3g; 3h; 3i; 3j; 3k; 3l; 3m; 3n; 3o) in der axialen Richtung erstreckt.

3. Schneidrad (1a; 1b; 1c; 1d; 1e; 1f; 1g; 1h; 1i; 1j; 1k; 11; 1m; 1l) nach Anspruch 2, wobei die mindestens eine Nut (3a; 3b; 3c; 3d; 3e; 3f; 3g; 3h; 3i; 3j; 3k; 3l; 3m; 3n; 3o) eine Länge von einem bis drei Viertel der Dicke des Schneidrads (1a; 1b; 1c; 1d; 1e; 1f; 1g; 1h; 1i; 1j; 1k; 1l; 1m; 11) in der axialen Richtung hat.

4. Schneidrad (1a; 1b; 1c; 1d; 1e; 1f; 1g; 1h; 1i; 1j; 1k; 1l; 1m; 11) nach Anspruch 1, wobei sich die mindestens eine Nut (3a; 3b; 3c; 3d; 3e; 3f; 3g; 3h; 3i; 3j; 3k; 3l; 3m; 3n; 3o) schräg zu der axialen Richtung erstreckt.

5. Schneidrad (1a; 1b; 1c; 1d; 1e; 1f; 1g; 1h; 1i; 1j; 1k; 1l; 1m; 11) nach Anspruch 4, wobei sich die mindestens eine Nut (3a; 3b; 3c; 3d; 3e; 3f; 3g; 3h; 3i; 3j; 3k; 3l; 3m; 3n; 3o) spiralförmig entlang des Wellenlochs (2) erstreckt.

6. Schneidrad (1a; 1b; 1c; 1d; 1e; 1f; 1g; 1h; 1i; 1j; 1k; 1l; 1m; 11) nach Anspruch 1, wobei die mindestens eine Nut (3a; 3b; 3c; 3d; 3e; 3f; 3g; 3h; 3i; 3j; 3k; 31; 3m; 3n; 3o) eine rechteckige Form mit einem Querschnitt einer Form hat, welche aus U-förmigen und V-förmigen Formen ausgewählt ist.

7. Schneidrad (1a; 1b; 1c; 1d; 1e; 1f; 1g; 1h; 1i; 1j; 1k; 1l; 1m; 11) nach Anspruch 1, wobei sich eine Tiefe der mindestens einen Nut (3a; 3b; 3c; 3d; 3e; 3f; 3g; 3h; 3i; 3j; 3k; 3l; 3m; 3n; 30) von einer Fläche der Seitenebenen hin zu ihrem Inneren verringert.

8. Schneidrad (1a; 1b; 1c; 1d; 1e; 1f; 1g; 1h; 1i; 1j; 1k; 1l; 1m; 11) nach Anspruch 1, wobei eine Tiefe der mindestens einen Nut (3a; 3b; 3c; 3d; 3e; 3f; 3g; 3h; 3i; 3j; 3k; 3l; 3m; 3n; 3o) entlang der axialen Richtung konstant ist.

9. Schneidrad (1a; 1b; 1c; 1d; 1e; 1f; 1g; 1h; 1i; 1j; 1k; 1l; 1m; 11) nach Anspruch 1, wobei die mindestens eine Nut (3a; 3b; 3c; 3d; 3e; 3f; 3g; 3h; 3i; 3j; 3k; 31; 3m; 3n; 3o) in einem gleichen Abstand dazwischen ausgebildet ist.

10. Schneidrad (1a; 1b; 1c; 1d; 1e; 1f; 1g; 1h; 1i; 1j; 1k; 1l; 1m; 11) nach Anspruch 1, wobei die mindestens eine Nut (3a; 3b; 3c; 3d; 3e; 3f; 3g; 3h; 3i; 3j; 3k; 3l; 3m; 3n; 3o) erste Nuten hat, welche sich von einer der Seitenebenen erstrecken, und zweite Nuten, welche sich von der anderen der Seitenebenen erstrecken, und
die ersten und zweiten Nuten abwechselnd in der Umfangsrichtung des Wellenlochs (2) positioniert sind.

11. Schneidrad (1a; 1b; 1c; 1d; 1e; 1f; 1g; 1h; 1i; 1j; 1k; 1l; 1m; 11) nach Anspruch 1, wobei die mindestens eine Nut (3a; 3b; 3c; 3d; 3e; 3f; 3g; 3h; 3i; 3j; 3k; 3l; 3m; 3n; 3o) eine Breite hat, welche mit sich erhöhenden Abstand von dem Wellenloch (2) steigt.

12. Schneidrad (1a; 1b; 1c; 1d; 1e; 1f; 1g; 1h; 1i; 1j; 1k; 1l; 1m; 11) nach Anspruch 1, des Weiteren mit mindestens einem Durchgangsloch (7), welches sich in die Dickenrichtung des Schneidrads (1a; 1b; 1c; 1d; 1e; 1f; 1g; 1h; 1i; 1j; 1k; 1l; 1m; 11) erstreckt.

13. Schneidrad (1a; 1b; 1c; 1d; 1e; 1f; 1g; 1h; 1i; 1j; 1k; 1l; 1m; 11) nach Anspruch 12, wobei eines des mindestens eines Durchgangslochs (7) mit einer der mindesten einen Nut (3a; 3b; 3c; 3d; 3e; 3f; 3g; 3h; 3i; 3j; 3k; 3l; 3m; 3n; 3o) verbunden ist.

14. Schneidrad (1a; 1b; 1c; 1d; 1e; 1f; 1g; 1h; 1i; 1j; 1k; 1l; 1m; 11) nach Anspruch 1, des Weiteren mit mindestens einer Aussparung (8; 9), welche bei mindestens einer der Seitenebenen von sich ausgebildet ist.

15. Schneidrad (1a; 1b; 1c; 1d; 1e; 1f; 1g; 1h; 1i; 1j; 1k; 1l; 1m; 11) nach Anspruch 14, wobei die mindestens eine Aussparung (8; 9) eine Halbkugelform hat.

16. Schneidrad (1a; 1b; 1c; 1d; 1e; 1f; 1g; 1h; 1i; 1j; 1k; 1l; 1m; 11) nach Anspruch 14, wobei sich die mindestens eine Aussparung (8; 9) senkrecht zu der radialen Richtung des Schneidrades (1a; 1b; 1c; 1d; 1e; 1f; 1g; 1h; 1i; 1j; 1k; 1l; 1m; 11) erstreckt.

17. Schneidwerkzeug mit:
einem Schneidrad (1a; 1b; 1c; 1d; 1e; 1f; 1g; 1h; 1i; 1j; 1k; 1l; 1m; 11) nach einem der Ansprüche 1 bis 16; einer Drehwelle (6), welche in das Wellenloch (2) des Schneidrads (1a; 1b; 1c; 1d; 1e; 1f; 1g; 1h; 1i; 1j; 1k; 1l; 1m; 11) eingepasst ist;
einem Halteelement (5), welches die Drehwelle (2) abstützt.

## Revendications

1. Molette (1a ; 1b ; 1c ; 1d ; 1e ; 1f ; 1g ; 1h ; 1i ; 1j ; 1k ; 1l ; 1m ; 11) pour entailler des matériaux cassants, qui comprend :
un disque avec deux plans latéraux, avec un bord en forme de V formé au niveau de sa périphérie extérieure,
et avec un trou d'arbre (2) formé en son centre pour insérer un arbre de rotation (6),
dans laquelle au moins une rainure (3a ; 3b ; 3c ; 3d ; 3e ; 3f ; 3g ; 3h ; 3i ; 3j ; 3k ; 3l ; 3m ; 3n ; 3o) s'étend depuis une première surface desdits plans latéraux le long dudit trou d'arbre (2),
**caractérisée en ce que**
ladite au moins une rainure (3a ; 3b ; 3c ; 3d ; 3e ; 3f ; 3g ; 3h ; 3i ; 3j ; 3k ; 3l ; 3m ; 3n ; 3o), lorsqu'elle est observée dans la direction axiale, a une longueur inférieure à l'épaisseur de la molette (1a ; 1b ; 1c ; 1d ; 1e ; 1f ; 1g ; 1h ; 1i ; 1j ; 1k ; 1l ; 1m ; 11).

2. Molette (1a ; 1b ; 1c ; 1d ; 1e ; 1f ; 1g ; 1h ; 1i ; 1j ; 1k ; 1l ; 1m ; 11) selon la revendication 1, dans laquelle ladite au moins une rainure (3a ; 3b ; 3c ; 3d ; 3e ; 3f ; 3g ; 3h ; 3i ; 3j ; 3k ; 3l ; 3m ; 3n ; 3o) , s'étend dans la direction axiale.

3. Molette (1a ; 1b ; 1c ; 1d ; le ; 1f ; 1g ; 1h ; 1i ; 1j ; 1k ; 1l ; 1m ; 11) selon la revendication 2, dans laquelle ladite au moins une rainure (3a ; 3b ; 3c ; 3d ; 3e ; 3f ; 3g ; 3h ; 3i ; 3j ; 3k ; 3l ; 3m ; 3n ; 3o), a une longueur dans la direction axiale mesurant entre ¼ et ¾ de l'épaisseur de la molette (1a ; 1b ; 1c ; 1d ; le ; 1f ; 1g ; 1h ; 1i ; 1j ; 1k ; 1l ; 1m ; 11).

4. Molette (1a ; 1b ; 1c ; 1d ; le ; 1f ; 1g ; 1h ; 1i ; 1j ; 1k ; 1l ; 1m ; 11) selon la revendication 1, dans laquelle ladite au moins une rainure (3a ; 3b ; 3c ; 3d ; 3e ; 3f ; 3g ; 3h ; 3i ; 3j ; 3k ; 3l ; 3m ; 3n; 3o), s'étend en oblique par rapport à la direction axiale.

5. Molette (1a ; 1b ; 1c ; 1d ; 1e ; 1f ; 1g ; 1h ; 1i ; 1j ; 1k ; 1l ; 1m ; 11) selon la revendication 4, dans laquelle ladite au moins une rainure (3a ; 3b ; 3c ; 3d ; 3e ; 3f ; 3g ; 3h ; 3i ; 3j ; 3k ; 3l ; 3m ; 3n ; 3o), s'étend en spirale 1e long du trou d'arbre (2).

6. Molette (1a ; 1b ; 1c ; 1d ; 1e ; 1f ; 1g ; 1h ; 1i ; 1j ; 1k ; 1l ; 1m ; 11) selon la revendication 1, dans laquelle ladite au moins une rainure (3a ; 3b ; 3c ; 3d ; 3e ; 3f ; 3g ; 3h ; 3i ; 3j ; 3k ; 3l ; 3m ; 3n ; 3o) a une forme rectangulaire avec une section transversale d'une forme sélectionnée à partir de formes en U ou en V.

7. Molette (1a ; 1b ; 1c ; 1d ; 1e ; 1f ; 1g ; 1h ; 1i ; 1j ; 1k ; 1l ; 1m ; 11) selon la revendication 1, dans laquelle une profondeur de ladite au moins une rainure (3a ; 3b ; 3c ; 3d ; 3e ; 3f ; 3g ; 3h ; 3i ; 3j ; 3k ; 3l ; 3m ; 3n ; 3o) diminue à partir d'une surface desdits plans latéraux vers sa partie intérieure.

8. Molette (1a ; 1b ; 1c ; 1d ; 1e ; 1f ; 1g ; 1h ; 1i ; 1j ; 1k ; 1l ; 1m ; 11) selon la revendication 1, dans laquelle une profondeur de ladite au moins une rainure (3a ; 3b ; 3c ; 3d ; 3e ; 3f ; 3g ; 3h ; 3i ; 3j ; 3k ; 3l ; 3m ; 3n ; 3o) est constante 1e long de la direction axiale.

9. Molette (1a ; 1b ; 1c ; 1d ; 1e ; 1f ; 1g ; 1h ; 1i ; 1j ; 1k ; 1l ; 1m ; 11) selon la revendication 1, dans laquelle ladite au moins une rainure (3a ; 3b ; 3c ; 3d ; 3e ; 3f ; 3g ; 3h ; 3i ; 3j ; 3k ; 3l ; 3m ; 3n ; 3o) est formée à distance égale.

10. Molette (1a ; 1b ; 1c ; 1d ; le ; 1f ; 1g ; 1h ; 1i ; 1j ; 1k ; 1l ; 1m ; 11) selon la revendication 1, dans laquelle ladite au moins une rainure (3a ; 3b ; 3c ; 3d ; 3e ; 3f ; 3g ; 3h ; 3i ; 3j ; 3k ; 3l ; 3m ; 3n ; 3o) comprend des premières rainures s'étendant depuis un desdits plans latéraux et des secondes rainures s'étendant depuis l'autre plan desdits plans latéraux, et
lesdites premières et secondes rainures sont situées alternativement dans la direction de la circonférence dudit trou d'arbre (2).

11. Molette (1a ; 1b ; 1c ; 1d ; 1e ; 1f ; 1g ; 1h ; 1i ; 1j ; 1k ; 1l ; 1m ; 11) selon la revendication 1, dans laquelle ladite au moins une rainure (3a ; 3b ; 3c ; 3d ; 3e ; 3f ; 3g ; 3h ; 3i ; 3j ; 3k ; 3l ; 3m ; 3n ; 3o) a une largeur augmentant avec l'augmentation de la distance à partir du trou d'arbre (2).

12. Molette (1a ; 1b ; 1c ; 1d ; 1e ; 1f ; 1g ; 1h ; 1i ; 1j ; 1k ; 1l ; 1m ; 11) selon la revendication 1, comprenant en outre au moins un trou traversant (7) s'étendant dans la direction de l'épaisseur de la molette (1a ; 1b ; 1c ; 1d ; 1e ; 1f ; 1g ; 1h ; 1i ; 1j ; 1k ; 1l ; 1m ; 11).

13. Molette (1a ; 1b ; 1c ; 1d ; 1e ; 1f ; 1g ; 1h ; 1i ; 1j ; 1k ; 1l ; 1m ; 11) selon la revendication 12, dans laquelle au moins un trou traversant (7) est raccordé à au moins une rainure (3a ; 3b ; 3c ; 3d ; 3e ; 3f ; 3g ; 3h ; 3i ; 3j ; 3k ; 3l ; 3m ; 3n ; 3o).

14. Molette (1a ; 1b ; 1c ; 1d ; 1e ; 1f ; 1g ; 1h ; 1i ; 1j ; 1k ; 1l ; 1m ; 11) selon la revendication 1, comprenant en outre au moins une encoche (8 ; 9) formée au niveau d'au moins un desdits plans latéraux de cette molette.

15. Molette (1a ; 1b ; 1c ; 1d ; 1e ; 1f ; 1g ; 1h ; 1i ; 1j ; 1k ; 1l ; 1m ; 11) selon la revendication 14, dans laquelle ladite au moins une encoche (8 ; 9) a une forme de demi-sphère.

16. Molette (1a ; 1b ; 1c ; 1d ; 1e ; 1f ; 1g ; 1h ; 1i ; 1j ; 1k; 1l ; 1m ; 11) selon la revendication 14, dans laquelle ladite au moins une encoche (8 ; 9) s'étend à la perpendiculaire de la direction radiale de la molette (1a ; 1b ; 1c ; 1d ; le ; 1f ; 1g ; 1h ; 1i ; 1j ; 1k ; 1l ; 1m ; 11).

17. Dispositif de coupe qui comprend :
une molette (1a ; 1b ; 1c ; 1d ; 1e ; 1f ; 1g ; 1h ; 1i ; 1j ; 1k ; 1l ; 1m ; 11) selon l'une des revendications 1 à 16 ;
un arbre de rotation (6) monté sur le trou d'arbre (2) de ladite molette (1a ; 1b ; 1c ; 1d ; 1e ; 1f ; 1g ; 1h ; 1i ; 1j ; 1k ; 1l ; 1m ; 11) ; et
un support (5) supportant l'arbre de rotation (2).
